# EUROPEAN PATENT APPLICATION

(11) **EP 4 560 656 A1**
(43) Date of publication of application: **28.05.2025**
(21) Application number: 24211686.1
(22) Date of filing: 08.11.2024
(51) Int. Cl.: H01F 27/02, H01F 19/08, H01F 27/28, H01F 27/26, H01F 41/00, H01L 23/495, H01L 23/00

(54) **LEADFRAME-BASED INTEGRATED TRANSFORMER PACKAGES**

(30) Priority: 27.11.2023 US 202318519254
(71) Applicant: Allegro MicroSystems, LLC, Manchester, NH 03103-3353 (US)
(72) Inventor: CHANDRA, Harry, Phoenix (US); HEALEY, Natasha, Manchester (US); WONG, Harianto, Southborough (US)
(74) Representative: South, Nicholas Geoffrey

(57) **Abstract**

Systems, structures, packages, circuits, and methods provide leadframe-based packages with integrated IC-transformer structures having a transformer providing galvanic isolation for included IC die. An example leadframe-based voltage-isolated IC package includes a leadframe substrate with first and second leadframe, a magnetic core disposed on one side of the leadframe substrate, first and second IC die disposed on the other side of the leadframe substrate, a body including molding material encapsulating the first and second IC die; first and second coils configured about the magnetic core, and a wall configured to surround the magnetic core. The packages and modules may include various types of circuits; in some examples, chip packages or modules may include a galvanically isolated gate driver or other high voltage circuit.

## Description

### BACKGROUND

Solid state switches typically include a transistor structure. The controlling electrode of the switch, usually referred to as its gate (or base), is typically controlled (driven) by a switch drive circuit, sometimes also referred to as gate drive circuit. Such solid state switches are typically voltage-controlled, turning on when the gate voltage exceeds a manufacturer-specific threshold voltage by a margin, and turning off when the gate voltage remains below the threshold voltage by a margin.

Switch drive circuits typically receive their control instructions from a controller such as a pulse-width-modulated (PWM) controller via one or more switch driver inputs. Switch drive circuits deliver their drive signals directly (or indirectly via networks of active and passive components) to the respective terminals of the switch (gate and source).

Some electronic systems, including ones with solid state switches, have employed galvanic isolation to prevent undesirable DC currents flowing from one side of an isolation barrier to the other. Such galvanic isolation can be used to separate circuits in order to protect users from coming into direct contact with hazardous voltages.

Various transmission techniques are available for signals to be sent across galvanic isolation barriers including optical, capacitive, and magnetic coupling techniques. Magnetic coupling typically relies on use of a transformer to magnetically couple circuits on the different sides of the transformer, typically referred to as the primary and secondary sides, while also providing galvanic separation of the circuits.

Transformers used for magnetic-coupling isolation barriers typically utilize a magnetic core to provide a magnetic path to channel flux created by the currents flowing in the primary and secondary sides of the transformer. Magnetic-coupling isolation barriers have been shown to have various drawbacks, including manufacturing problems, for integrated circuit (IC) packages due to the included magnetic core.

### SUMMARY

Aspect of the present disclosure are directed to transformer-based integrated circuit (IC) packages having one or more fractional coil structures.

One general aspect of the present disclosure includes a leadframe-based voltage-isolated integrated circuit (IC) package. The leadframe-based voltage-isolated IC package can include a leadframe substrate having opposed first and second sides, with the leadframe substrate including: first and second leadframes that are galvanically separate; a magnetic core disposed on the first side of the leadframe substrate, where the magnetic core may include a soft ferromagnetic material; first and second integrated circuit (IC) die disposed on the second side of the leadframe substrate, where the first and second IC die are connected to the first and second leadframes, respectively; a body including molding material encapsulating the first and second IC die; first and second coils configured about the magnetic core and connected to the first and second leadframes, respectively, where the first and second coils and magnetic core are configured as a transformer; and a wall configured to surround the magnetic core.

Implementations may include one or more of the following features. The wall of the IC package may be integral with the body and provides an enclosure volume within the body, and where the magnetic core is disposed in the enclosure volume. The IC package may include an encapsulant disposed in the enclosure volume for protection of the magnetic core. The encapsulant may include silicone. The IC package may include a cover attached to the wall. The cover may be integral with the wall. The first and/or second coil may include insulated wire. The first and/or second coil may include uninsulated wire. The first and/or second coil may include insulated ribbon cables. The first and/or second coil may include flexible ribbon cables. The first and second coils can be configured as primary and secondary coils in a step-up transformer configuration. The magnetic core may include ferrite. The magnetic core may include a nickel alloy. The magnetic core may include iron particles. The leadframe substrate may include a molded leadframe substrate.

Another general aspect of the present disclosure includes a method of making a leadframe-based voltage-isolated integrated circuit (IC) package. The method can include providing a leadframe substrate having opposed first and second sides, where the leadframe substrate includes first and second leadframes that are galvanically separate; providing first and second integrated circuit (IC) die disposed on the second side of the leadframe substrate, where the first and second IC die are connected to the first and second leadframes, respectively; providing a body including molding material encapsulating the first and second IC die; providing a magnetic core disposed on the first side of the leadframe substrate, where the magnetic core may include a soft ferromagnetic material; providing first and second coils configured about the magnetic core and connected to the first and second leadframes, respectively, where the first and second coils and magnetic core are configured as a transformer; and providing a wall configured to surround the magnetic core.

Implementations may include one or more of the following features. Providing the wall may include forming the wall as part of the body. Providing the wall may include affixing a cover to the body, where the wall is integral with the cover. The wall can provide an enclosure volume for the magnetic core. The method may include providing an encapsulant disposed in the enclosure volume for encapsulating the magnetic core. The encapsulant may include silicone or any other suitable encapsulant material. The first and/or second coil may include insulated wire. The first and/or second coil may include uninsulated wire. The first and/or second coil may include insulated ribbon cables. The first and/or second coil may include flexible ribbon cables. The first and second coils can be configured as primary and secondary coils in a step-up configuration. Providing the first and second IC die may include connecting the first and second IC die to the first and second leadframes, respectively, with wire bonds. Providing the first and second IC die may include connecting the first and second IC die to the first and second leadframes, respectively, using flip chip attachments. The magnetic core may include ferrite. The magnetic core may include a nickel alloy. The magnetic core may include iron particles. The leadframe substrate may include a molded leadframe substrate.

The features and advantages described herein are not all-inclusive; many additional features and advantages will be apparent to one of ordinary skill in the art in view of the drawings, specification, and claims. Moreover, it should be noted that the language used in the specification has been selected principally for readability and instructional purposes, and not to limit in any way the scope of the present disclosure, which is susceptible of many embodiments. What follows is illustrative, but not exhaustive, of the scope of the present disclosure.

### BRIEF DESCRIPTION OF THE DRAWINGS

The manner and process of making and using the disclosed embodiments may be appreciated by reference to the figures of the accompanying drawings. In the figures like reference characters refer to like components, parts, elements, or steps/actions; however, similar components, parts, elements, and steps/actions may be referenced by different reference characters in different figures. It should be appreciated that the components and structures illustrated in the figures are not necessarily to scale, emphasis instead being placed upon illustrating the principals of the concepts described herein. Furthermore, embodiments are illustrated by way of example and not limitation in the figures, in which:
FIGS. 1A-1B show perspective and side views of an example leadframe-based integrated transformer-IC package, in accordance with the present disclosure;
FIG. 2 includes Views A-E showing top, side, bottom, top isometric, and bottom isometric views, respectively, of an example leadframe-based integrated transformer-IC package, in accordance with the present disclosure;
FIG. 3 shows a perspective view of a further example leadframe-based integrated transformer-IC package having a cover lid, in accordance with the present disclosure; and
FIG. 4 is a diagram showing an example method of fabricating a leadframe-based integrated transformer-IC package, in accordance with the present disclosure.

### DETAILED DESCRIPTION

The features and advantages described herein are not all-inclusive; many additional features and advantages will be apparent to one of ordinary skill in the art in view of the drawings, specification, and claims. Moreover, it should be noted that the language used in the specification has been selected principally for readability and instructional purposes, and not to limit in any way the scope of the inventive subject matter. The subject technology is susceptible of many embodiments. What follows is illustrative, but not exhaustive, of the scope of the subject technology.

Aspects of the present disclosure are directed to and include systems, structures, circuits, and methods providing transformers and transformer structures that can be used for galvanic isolation (a.k.a., voltage isolation). Embodiments and examples can include leadframe-based packages with integrated IC-transformer structures having a core and coils in a transformer configuration and providing galvanic isolation for included IC die. In some embodiments, a transformer may have, e.g., a step up, a step down, or a power transformer configuration. Signals and power may be transferred from the primary side of the transformer to the secondary side.

The IC packages and modules may include various types of circuits; in some examples, IC packages or modules may include a galvanically isolated gate driver or other high voltage circuit, etc. First and second semiconductor die having one or more integrated circuits (a.k.a., "IC die") can be included in the packages. Such integrated circuits can include, e.g., but are not limited to, high-voltage circuits such as galvanically-isolated gate drivers configured to drive an external gate on a solid-state switch, e.g., a field effect transistor (FET), a metal oxide semiconductor FET (MOSFET), a metal semiconductor FET (MESFET), a gallium nitride FET (GaN FET), a high electron mobility transistor (HEMT), a silicon carbide FET (SiC FET), an insulated gate bipolar transistor (IGBT), or another load. In some embodiments, an IC die may be packaged. In some embodiments, an IC die may be unpackaged (bare).

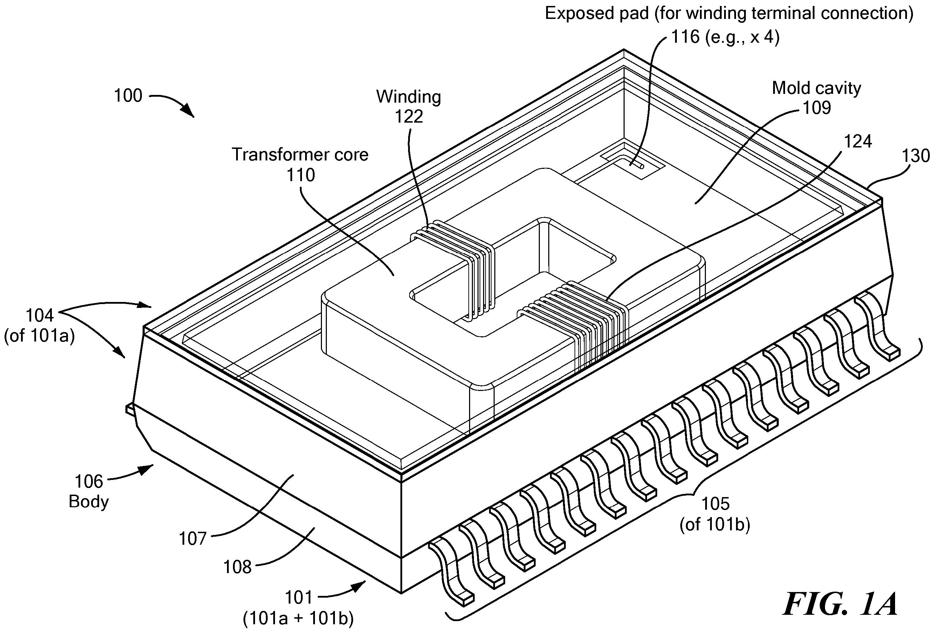

FIGS. 1A-1B show perspective and side views, respectively, of an example leadframe-based integrated transformer-IC package 100, in accordance with the present disclosure. Package 100 can include a leadframe substrate 101 having first and second leadframes 101a-101b. Leadframe substrate 101 is shown with first and second opposed sides 102 and 103. Leadframe substrate 101 can include first and second lead sets 104 and 105, respectively connected to first and second leadframes 101a-101b, which may be galvanically isolated (physically separate), as shown. The lead sets 104, 105 may have any suitable desired configuration (e.g., number and geometries of leads). For example, while the leads are shown with a configuration bent away from the first side of the substrate 101, i.e., away from the magnetic core and toward the IC die, the leads may be bent the opposite way (toward the magnetic core) in other embodiments.

Package 100 includes a body 106, which can be made of or include one or more suitable materials, e.g., a mold compound, such as used for compression molding. Body 106 can include first and second portions 107, 108. In some embodiments, first and second body portions 107, 108 may be or include upper and lower mold portions, e.g., made by separate molding processes. Body cavity 109 (a.k.a., "mold cavity") may be located, e.g., within first body portion 107. In some embodiments, package 100 may be configured as a small outline integrated circuit (SOIC) package.

Package 100 can include a magnetic core 100 disposed in cavity 109. Core 110 is shown with cross-sections 110a-110b. Core 110 can include or be of any suitable soft (referring to magnetic property) ferromagnetic material. In some embodiments, core 110 can include ferrite, nickel alloy, and/or ferrosilicon, etc. Core 110 can include a sintered soft ferromagnetic material in some embodiments. First and second transformer coils 122, 124 can be disposed about (wound around) core 110 in a transformer configuration. Coils 122, 124 may be connected to wireframe substrate 101, e.g., to leadframes 101a, 101b, respectively, at exposed pads 116, as shown. In some embodiments, cavity 109 may include a compliant material, e.g., an encapsulant (a.k.a., and encapsulate) such as a silicone material, for protecting core 110. In other embodiments. The cavity 109 may be devoid of an encapsulant, in some embodiments.

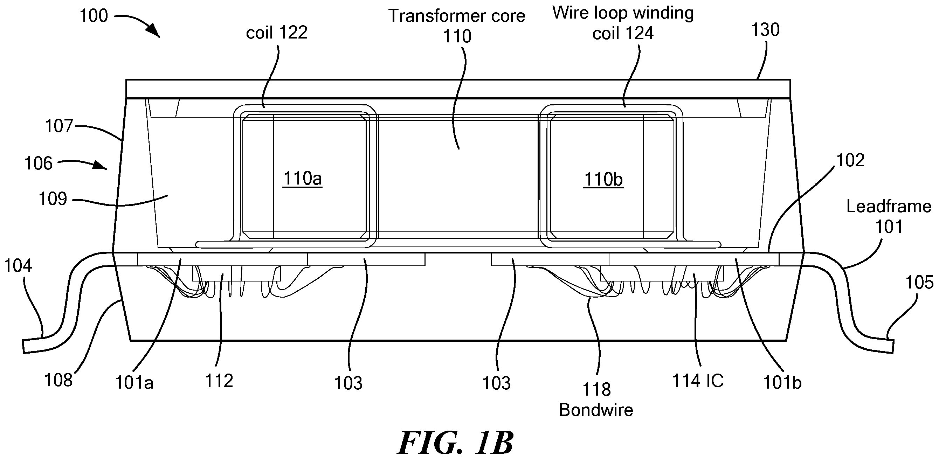

As shown in FIG. 1B, first and/or second integrated circuit (IC) die 112, 114 (a.k.a., "semiconductor die") may be disposed on (e.g., bonded to) one of the opposed sides 102, 103 of leadframe substrate 101, e.g., on second side 103, as shown. IC die 112, 114 may be connected to the leadframe substrate 101 by suitable connections, e.g., wire bonds 118 (as shown), flip-chip connections, etc.

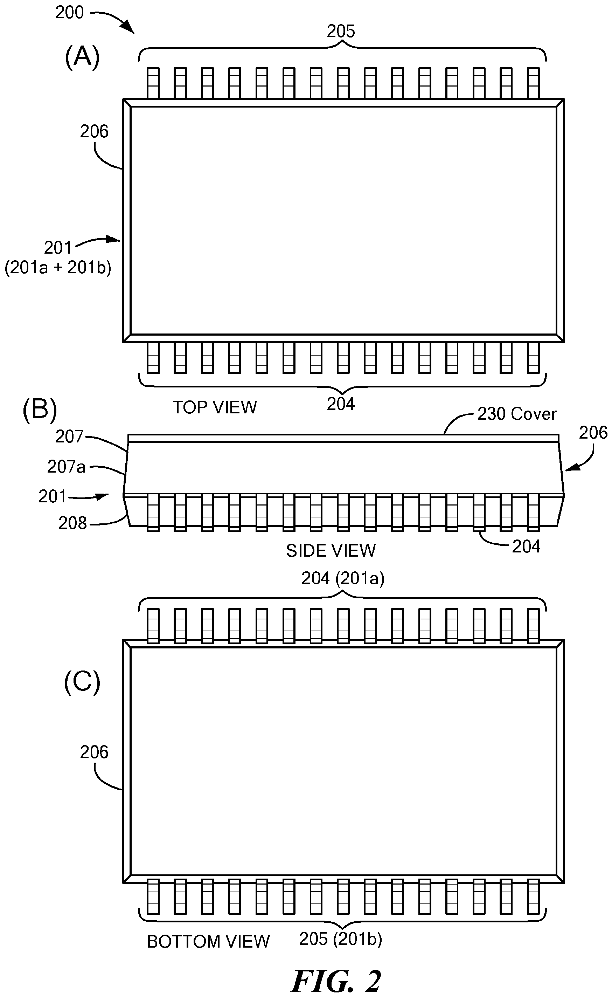

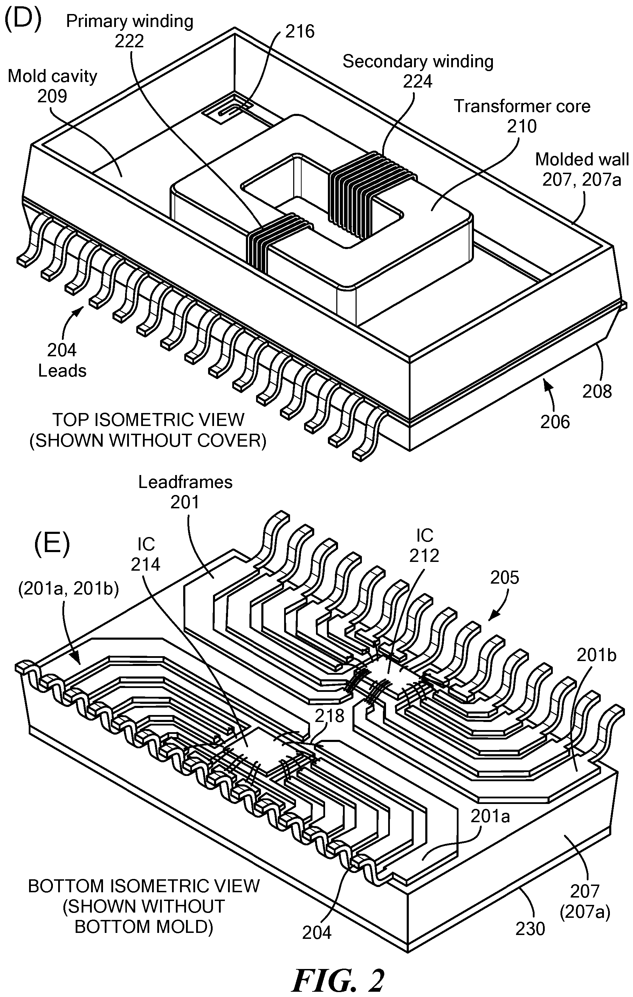

FIG. 2 includes Views A-E showing top, side, bottom, top isometric, and bottom isometric views, respectively, of an example leadframe-based integrated transformer-IC package 200, in accordance with the present disclosure.

Package 200 can include a leadframe substrate 201 having first and second leadframes 201a-201b and first and second opposed sides 202 and 203. Leadframe substrate 201 can include first and second lead sets 204 and 205, respectively connected to first and second leadframes 201a-201b, which may be galvanically isolated (physically separate), as shown (View E). Package 200 includes a body 206, which can be made of or include one or more suitable materials, e.g., a mold compound, such as used for compression molding. Body 206 can include first and second portions 207, 208. In some embodiments, first and second body portions 207, 208 may include upper and lower mold portions, e.g., made by separate molding processes. Body cavity 209 (a.k.a., "mold cavity" or "enclosure volume") may be located, e.g., within first body portion 207.

Package 200 can include a magnetic core 210 disposed in cavity 209. Core 210 is shown with cross-sections 210a-210b. Core 210 can include or be of any suitable soft (referring to magnetic property) ferromagnetic material. In some embodiments, core 210 can include ferrite. First and second transformer coils 222, 224 can be disposed about (wound around) core 210 in a transformer configuration. Coils 222, 224 may be connected to wireframe substrate 201, e.g., at exposed pads 216 as shown. As shown, first body portion 207 can include or present a wall 207a, which can be configured to surround (e.g., partially or fully enclose) core 210 and may define or include cavity (enclosure volume) 209. In some embodiments, cavity (enclosure volume) 209 may include a soft/compliant material, e.g., an encapsulant (encapsulate) such as a silicone material, for protecting core 210. In other embodiments, the cavity 209 may be devoid of an encapsulant. A cover 230 may be included to facilitate enclosure of cavity 209. View D shows a top isometric view of package 200 with cover 230 removed.

First and/or second integrated circuit (IC) die 212, 214 (a.k.a., "semiconductor die") may be disposed on (e.g., bonded to) side 203, as shown in View E. View E shows a bottom isometric view with bottom body portion (a.k.a., "bottom mold") 208 removed. IC die 212, 214 may be connected to the leadframe substrate 201 by suitable connections, e.g., wire bonds 218 (as shown), flip chip on leadframe connections (FCOL) such as copper posts/pads, etc.

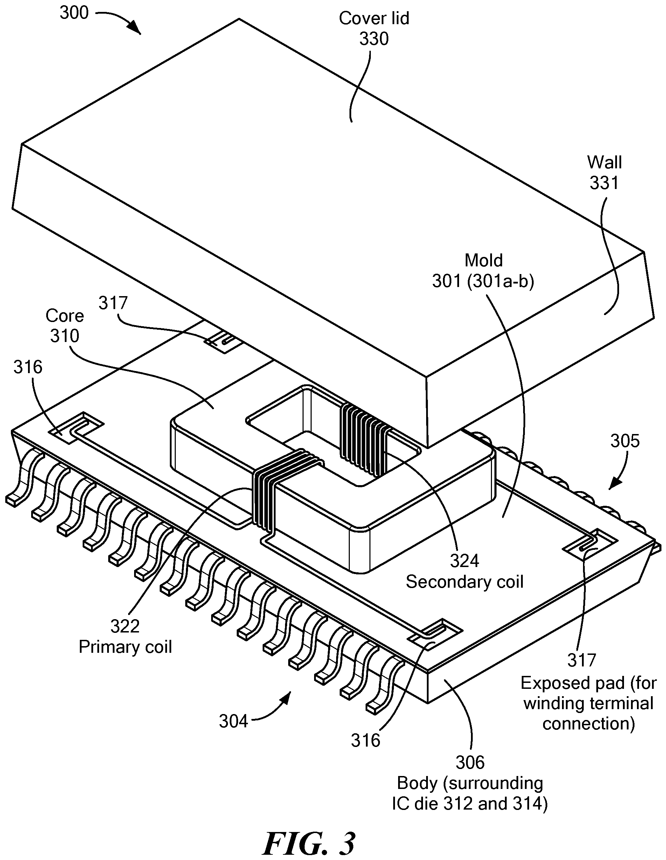

While FIGS. 1-2 show embodiments having bodies with body cavities, other embodiments without body cavities are included within the scope of the present disclosure, e.g., as shown in FIG. 3.

FIG. 3 shows a perspective view of a further example leadframe-based integrated transformer-IC package 300 having a cover lid (a.k.a., "cover"), in accordance with the present disclosure. Package 300 includes a molded leadframe 301 within or part of body 306. Molded lead frame 301 can include first and second molded leadframes 301a-301b (not shown), which can be galvanically isolated and connected to lead sets 304 and 305, respectively. Magnetic core 310 is shown disposed on body 306. Core 310 can be made of or include any suitable soft ferromagnetic materials or materials. IC die 312 and 314 can be included in body 306 and connected to leadframes 301a and 301b, respectively. Primary and secondary coils 322, 324 are shown configured (wrapped) about core 310 in a transformer configuration. Primary and secondary coils 322, 324 can be connected to exposed pads 316, 317 of leadframe 301a, 301b, respectively. Exposed pads 316, 317 may be accessible by holes/apertures, e.g., formed in mold material of molded leadframe 301 or mold material of body 306. The transformer configuration of primary and secondary coils 322, 324 and core 310 can provide galvanic separation of IC 312 and 314 while allowing transfer of power and/or signals between primary and secondary sides of the transformer (e.g., between IC 312 and IC 314). In some embodiments, primary and secondary coils 322, 324 may be configured in a step up transformer configuration with secondary coil 324 being on the higher-voltage side, as shown.

As shown, package 300 may include a cover lid 330 with wall 331 (shown partially removed). Cover lid 330 can be configured to fit together with body 306, e.g., around a perimeter of body 306, and cover and/or enclose (partially or fully) magnetic core 310. In some embodiments, a suitable soft compliant material, e.g., silicone gel, can be included within a volume of cover lid 300 and wall 331.

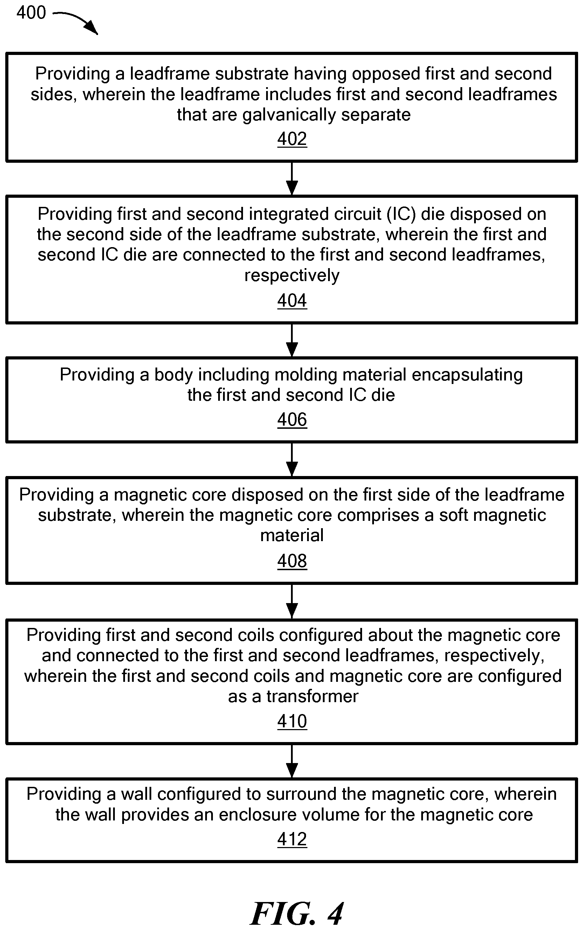

FIG. 4 is a diagram showing an example method 400 of fabricating a leadframe-based integrated transformer-IC package, in accordance with the present disclosure.

Method 400 can include providing a leadframe substrate having opposed first and second sides, wherein the leadframe includes first and second leadframes that are galvanically separate, as described at 402. First and second integrated circuit (IC) die can be disposed on the second side of the leadframe substrate, where the first and second IC die are connected to the first and second leadframes, respectively, as described at 404. In some embodiment, the second IC die can include a gate driver. A package body, including molding material encapsulating the first and second IC die, can be provided, as described at 406.

A magnetic core can be provided, disposed on the first side of the leadframe substrate, where the magnetic core comprises a soft magnetic material, as described at 408. First and second coils can be provided and configured about the magnetic core and connected to the first and second leadframes, respectively, where the first and second coils and magnetic core are configured as a transformer, as described at 410. In some embodiments, the transformer may be configured as a step up transformer. Method 400 can include providing a wall that is configured to surround the magnetic core, and the wall can provide an enclosure volume (cavity) for the magnetic core, as described at 412.

In some examples and/or embodiments, integrated circuits (ICs), e.g., in IC die 112 and 114 in FIG. 1B, or other conductive features of the primary and secondary sides of a transformer structure in an IC or transformer package according to the present disclosure can be fabricated or configured to have a desired separation distance (d) between certain parts or features, e.g., to meet internal creepage or external clearance requirements for a given pollution degree rating as defined by certain safety standards bodies such as the Underwriters Laboratories (UL) and the International Electrotechnical Commission (IEC). For example, a separation distance may be between closest (voltage) points of the respective circuits, e.g., the low-voltage (primary) side and high-voltage (secondary) side. For further example, such a separation distance may be the distance between any two voltage points between the primary and secondary sides, e.g., distance between die 112 and die 114 in FIG. 1B, or a distance between exposed leads connected to the die, may be or may be at least 1.2mm, 1.4mm, 1.5mm, 3.0mm, 4.0mm, 5.5mm, 7.2mm, 8.0mm, 10mm, or 10+mm in respective examples. Such a distance between conductive portions or areas of die can include any insulation covering a conductor, e.g., such as plastic coating of a wire/lead. Other distances between conductive parts, components, and/or features of an IC/transformer package may also be designed and implemented, e.g., to meet desired internal creepage, voltage breakdown, or external clearance requirements, e.g., between external leads.

In some examples and embodiments, a dielectric material (e.g., gel) may be used for potting and/or encapsulating (protecting) substrate systems, assemblies, and/or packages, including magnetic cores and/or IC die and/or interconnects from environmental conditions and/or to provide dielectric insulation. In some examples, a dielectric material may include, but is not limited to, one or more of the following materials: DOWSIL^{™} EG-3810 Dielectric Gel (made available by The Dow Chemical Corporation, a.k.a., "Dow"), and/or DOWSIL^{™} EG-3896 Dielectric Gel (made available by Dow), which has the ability to provide isolation greater than 20 kV/mm. Other suitable gel materials may also or instead be used, e.g., to meet or facilitate meeting/achieving voltage isolation specifications required by a given package design. DOWSIL^{™} EG-3810 is designed for temperature ranges from -60°C to 200°C and DOWSIL^{™} EG-3896 Dielectric Gel -40°C to +185°C; both of which can be used to meet typical temperature ranges for automotive applications.

Accordingly, embodiments and/or examples of the inventive subject matter can afford various benefits relative to prior art techniques. For example, embodiments and examples of the present disclosure can enable or facilitate use of smaller size packages for a given power, current. or voltage rating. Embodiments and examples of the present disclosure can enable or facilitate lower costs and higher scalability for manufacturing of IC packages/modules having voltage-isolated (galvanic isolation) IC die and transformers.

Various embodiments of the concepts, systems, devices, structures, and techniques sought to be protected are described above with reference to the related drawings. Alternative embodiments can be devised without departing from the scope of the concepts, systems, devices, structures, and techniques described.

It is noted that various connections and positional relationships (e.g., over, below, adjacent, etc.) may be used to describe elements and components in the description and drawings. These connections and/or positional relationships, unless specified otherwise, can be direct or indirect, and the described concepts, systems, devices, structures, and techniques are not intended to be limiting in this respect. Accordingly, a coupling of entities can refer to either a direct or an indirect coupling, and a positional relationship between entities can be a direct or indirect positional relationship.

As an example of an indirect positional relationship, positioning element "A" over element "B" can include situations in which one or more intermediate elements (e.g., element "C") is between elements "A" and elements "B" as long as the relevant characteristics and functionalities of elements "A" and "B" are not substantially changed by the intermediate element(s).

Also, the following definitions and abbreviations are to be used for the interpretation of the claims and the specification. The terms "comprise," "comprises," "comprising," "include," "includes," "including," "has," "having," "contains" or "containing," or any other variation are intended to cover a non-exclusive inclusion. For example, an apparatus, a method, a composition, a mixture, or an article, which includes a list of elements is not necessarily limited to only those elements but can include other elements not expressly listed or inherent to such apparatus, method, composition, mixture, or article.

Additionally, the term "exemplary" means "serving as an example, instance, or illustration." Any embodiment or design described as "exemplary" is not necessarily to be construed as preferred or advantageous over other embodiments or designs. The terms "one or more," and "at least one" indicate any integer number greater than or equal to one, i.e., one, two, three, four, etc.; those terms, however, may refer to fractional numbers/values greater than one where context admits (e.g., a number of windings of a coil may be a plurality having a fractional value such as 1.5, 2.75, 3.8, 6.6, etc.). The term "plurality" indicates any integer or fractional value greater than one, e.g., 1.33, 1.8, 2, 2.9, 5.75, etc. The term "connection" can include an indirect connection and a direct connection.

References in the specification to "embodiments," "one embodiment, "an embodiment," "an example embodiment," "an example," "an instance," "an aspect," etc., indicate that the embodiment described can include a particular feature, structure, or characteristic, but every embodiment may or may not include the particular feature, structure, or characteristic. Moreover, such phrases do not necessarily refer to the same embodiment. Further, when a particular feature, structure, or characteristic is described in connection with an embodiment, it may affect such feature, structure, or characteristic in other embodiments whether explicitly described or not.

Relative or positional terms including, but not limited to, the terms "upper," "lower," "right," "left," "vertical," "horizontal, "top," "bottom," and derivatives of those terms relate to the described structures and methods as oriented in the drawing figures. The terms "overlying," "atop," "on top, "positioned on" or "positioned atop" mean that a first element, such as a first structure, is present on a second element, such as a second structure, where intervening elements such as an interface structure can be present between the first element and the second element. The term "direct contact" means that a first element, such as a first structure, and a second element, such as a second structure, are connected without any intermediary elements.

Use of ordinal terms such as "first," "second," "third," etc., in the claims to modify a claim element does not by itself connote any priority, precedence, or order of one claim element over another, or a temporal order in which acts of a method are performed but are used merely as labels to distinguish one claim element having a certain name from another element having a same name (but for use of the ordinal term) to distinguish the claim elements.

The terms "approximately" and "about" may be used to mean within ±20% of a target (or nominal) value in some embodiments, within plus or minus (±) 10% of a target value in some embodiments, within ±5% of a target value in some embodiments, and yet within ±2% of a target value in some embodiments. The terms "approximately" and "about" may include the target value. The term "substantially equal" may be used to refer to values that are within ±20% of one another in some embodiments, within ±10% of one another in some embodiments, within ±5% of one another in some embodiments, and yet within ±2% of one another in some embodiments.

The term "substantially" may be used to refer to values that are within ±20% of a comparative measure in some embodiments, within ±10% in some embodiments, within ±5% in some embodiments, and yet within ±2% in some embodiments. For example, a first direction that is "substantially" perpendicular to a second direction may refer to a first direction that is within ±20% of making a 90° angle with the second direction in some embodiments, within ±10% of making a 90° angle with the second direction in some embodiments, within ±5% of making a 90° angle with the second direction in some embodiments, and yet within ±2% of making a 90° angle with the second direction in some embodiments.

The disclosed subject matter is not limited in its application to the details of construction and to the arrangements of the components set forth in the following description or illustrated in the drawings. The disclosed subject matter is capable of other embodiments and of being practiced and carried out in various ways.

Also, the phraseology and terminology used in this patent are for the purpose of description and should not be regarded as limiting. As such, the conception upon which this disclosure is based may readily be utilized as a basis for the designing of other structures, methods, and systems for carrying out the several purposes of the disclosed subject matter. Therefore, the claims should be regarded as including such equivalent constructions as far as they do not depart from the spirit and scope of the disclosed subject matter.

Although the disclosed subject matter has been described and illustrated in the foregoing exemplary embodiments, the present disclosure has been made only by way of example. Thus, numerous changes in the details of implementation of the disclosed subject matter may be made without departing from the spirit and scope of the disclosed subject matter.

Accordingly, the scope of this patent should not be limited to the described implementations but rather should be limited only by the spirit and scope of the following claims.

All publications and references cited in this patent are expressly incorporated by reference in their entirety.

## Claims

1. A leadframe-based voltage-isolated integrated circuit (IC) package comprising:
a leadframe substrate having opposed first and second sides, wherein the leadframe substrate includes first and second leadframes that are galvanically separate;
a magnetic core disposed on the first side of the leadframe substrate, wherein the magnetic core comprises a soft ferromagnetic material;
first and second integrated circuit (IC) die disposed on the second side of the leadframe substrate, wherein the first and second IC die are connected to the first and second leadframes, respectively;
a body including molding material encapsulating the first and second IC die;
first and second coils configured about the magnetic core and connected to the first and second leadframes, respectively, wherein the first and second coils and magnetic core are configured as a transformer; and
a wall configured to surround the magnetic core.

2. The IC package of claim 1, wherein the wall is integral with the body and provides an enclosure volume within the body, and wherein the magnetic core is disposed in the enclosure volume.

3. The IC package of claim 1, further comprising an encapsulant disposed in the enclosure volume for protection of the magnetic core.

4. The IC package of claim 1, further comprising a cover attached to the wall.

5. The IC package of claim 4, wherein the cover is integral with the wall.

6. A method of making a leadframe-based voltage-isolated integrated circuit (IC) package, the method comprising:
providing a leadframe substrate having opposed first and second sides, wherein the leadframe substrate includes first and second leadframes that are galvanically separate;
providing first and second integrated circuit (IC) die disposed on the second side of the leadframe substrate, wherein the first and second IC die are connected to the first and second leadframes, respectively;
providing a body including molding material encapsulating the first and second IC die;
providing a magnetic core disposed on the first side of the leadframe substrate, wherein the magnetic core comprises a soft ferromagnetic material;
providing first and second coils configured about the magnetic core and connected to the first and second leadframes, respectively, wherein the first and second coils and magnetic core are configured as a transformer; and
providing a wall configured to surround the magnetic core.

7. The method of claim 6, wherein providing the wall comprises forming the wall as part of the body.

8. The method of claim 6, wherein providing the wall comprises affixing a cover to the body, wherein the wall is integral with the cover.

9. The method of claim 6, wherein the wall provides an enclosure volume for the magnetic core, and further comprising providing an encapsulant disposed in the enclosure volume for encapsulating the magnetic core.

10. The method of claim 9, or the IC package of claim 3, wherein the encapsulant comprises silicone.

11. The method of claim 6, or the IC package of claim 1, wherein the first and/or second coil comprises insulated wire.

12. The method of claim 6, or the IC package of claim 1, wherein the first and/or second coil comprises uninsulated wire.

13. The method of claim 6, or the IC package of claim 1, wherein the first and/or second coil comprises insulated ribbon cables.

14. The method of claim 6, or the IC package of claim 1, wherein the first and/or second coil comprises flexible ribbon cables.

15. The method of claim 6, or the IC package of claim 1, wherein the first and second coils are configured as primary and secondary coils in a step-up configuration.

16. The method of claim 6, wherein providing the first and second IC die comprises connecting the first and second IC die to the first and second leadframes, respectively, with wire bonds.

17. The method of claim 6, wherein providing the first and second IC die comprises connecting the first and second IC die to the first and second leadframes, respectively, using flip chip attachments.

18. The method of claim 6, or the IC package of claim 1, wherein the magnetic core comprises ferrite.

19. The method of claim 6, or the IC package of claim 1, wherein the magnetic core comprises a nickel alloy.

20. The method of claim 6, or the IC package of claim 1, wherein the magnetic core comprises iron particles.

21. The method of claim 6, or the IC package of claim 1, wherein the leadframe substrate comprises a molded leadframe substrate.
